# FASCICULE DE BREVET EUROPEEN

(11) **EP 1 405 416 B1**
(45) Date de publication et mention de la délivrance du brevet: **21.06.2006**
(21) Numéro de dépôt: 02745541.9
(22) Date de dépôt: 19.06.2002
(51) Int. Cl.: H03K 17/94

(54) **PROCEDE ET DISPOSITIF DE DETECTION OPTIQUE DE LA POSITION D'UN OBJET**
VERFAHREN UND VORRICHTUNG ZUR OPTISCHEN POSITIONSERFASSUNG EINES GEGENSTANDS
METHOD AND DEVICE FOR OPTICAL DETECTION OF THE POSITION OF AN OBJECT

(30) Priorité: 21.06.2001 FR 0108186
(43) Date de publication de la demande: 07.04.2004
(73) Titulaire: H2I Technologies, 30900 Nîmes (FR)
(72) Inventeur: Cavalucci, Gilles, F-30000 Nimes (FR)
(74) Mandataire: Domange, Maxime
(86) Numéro de dépôt international: PCT/FR2002/002111
(87) Numéro de publication internationale: WO 2003/003580

(56) Documents cités:
- EP-A- 0 506 039
- EP-A- 0 559 357
- GB-A- 2 133 537
- US-A- 4 311 990

## Description

La présente invention est relative à un procédé et à un dispositif permettant la saisie de données, ainsi qu'à un système de détection optique de la position d'un objet ou organe, susceptibles d'être utilisé (respectivement incorporé) dans un tel procédé (respectivement dispositif).

Le domaine technique de l'invention est celui de la fabrication des claviers et des dispositifs similaires permettant une entrée manuelle de données à traiter par un calculateur numérique.

Il existe de nombreux systèmes optiques utilisés pour détecter la position d'un organe ou objet en vue de la saisie de données, en particulier de données alphanumériques.

Le brevet FR 2 443 173 décrit un clavier à touches mobiles comportant une pluralité de sources de lumière et une pluralité de capteurs de lumière permettant de détecter l'enfoncement des touches ; ce clavier est coûteux, car il nécessite un grand nombre de composants mécaniques et de composants optoélectroniques ; il est en outre complexe du fait de la dissémination des sources et des capteurs lumineux dans toute la zone où sont situées les touches.

Plus récemment ont été développés des dispositifs statiques (dénués de touches mobiles) de saisie de données.

Le document GB-A-2133537 décrit un système de détection optique de la position d'un doigt d'un utilisateur sur un écran ; ce système comporte des sources émettant un faisceau lumineux divergent afin d'augmenter la résolution du système sans multiplier le nombre d'émetteurs et de détecteurs.

Le brevet US-A-4,986,662 décrit un système similaire au précédent où les sources sont placées au foyer d'un réflecteur parabolique, afin de diminuer le nombre de composants optoélectroniques.

Un inconvénient de ces dispositifs résulte du fait qu'ils nécessitent de disposer les composants optiques (sources, détecteurs et le cas échéant réflecteurs) de façon sensiblement répartie sur tout le pourtour de la zone de saisie (ou zone surveillée), et avec une précision géométrique suffisante pour ne pas fausser les calculs effectués à partir des données représentatives des signaux délivrés par les détecteurs, pour déterminer la position, dans la zone de saisie, de l'obstacle (doigt ou autre) qui sert à déterminer la donnée choisie par l'utilisateur. Il en résulte que ces dispositifs restent relativement coûteux.

Le document EP 0 559 357 décrit un système d'alarme comportant un dispositif de détection de type « barrière photoélectrique » constitué de deux poteaux plantés dans le sol, équipés de quatre émetteurs produisant quatre faisceaux infrarouge superposés, et de récepteurs correspondants qui détectent l'interruption de ces faisceaux par des objets traversant cette barrière infrarouge) ; le système de traitement des signaux binaires délivrés par les détecteurs comporte successivement un multiplexeur, un générateur de graphiques représentant les interruptions des faisceaux infrarouges par passage d'un homme, animal ou objet, un préprocesseur, un réseau de neurones, un comparateur, un contrôleur relié à une alarme et à un dispositif d'affichage et/ou d'impression ; le réseau de neurones est utilisé pour reconnaître un type d'objet parmi des types d'objets prédéterminés (homme, animal, véhicule), en fonction de la représentation graphique élaborée à partir des signaux de détection de coupure des faisceaux infrarouges superposés, après apprentissage et par comparaison.

Ce système n'est pas conçu pour déterminer la position de l'objet dans la zone à surveiller ; il n'est pas non plus apte à le faire puisque ni les émetteurs, ni les détecteurs ne couvrent l'ensemble de la zone à surveiller.

Le document EP 0 506 039 décrit un dispositif de détection de la position du tranchant 8a, 8b d'un outil 8 de coupe par rapport à une encoche en V d'une plaque.

A cet effet, le dispositif comporte une source laser dirigée vers la fente en V séparant le tranchant du bord de la plaque de référence, ainsi qu'un système optique sensible aux franges résultant de la diffraction du faisceau laser par cette fente, et un réseau de neurones pour déterminer la position du tranchant à partir des signaux délivrés par le système optique ; ce dernier comporte, soit trois séries de photo-diodes alignées, soit une caméra CCD.

L'utilisation de franges de diffraction d'un faisceau laser n'est pas applicable à la détection de la position d'un doigt dans une zone de contour déterminé, dans la mesure notamment où la présence d'un doigt n'aboutit pas à la présence de franges de diffraction.

Un objectif de l'invention est de remédier, en partie au moins, aux inconvénients des procédés, dispositifs et systèmes connus de détection optique de la position d'un doigt (ou d'un objet pointeur) à l'intérieur d'une zone de contour prédéterminé.

Un objectif de l'invention est d'améliorer de tels procédés, dispositifs et systèmes et d'en faciliter l'application à un terminal statique d'entrée de données tel qu'un clavier.

A cet effet, l'invention consiste à numériser les signaux délivrés par des photodétecteurs sensibles à l'éclairement de la zone de saisie (ou zone de détection), pour obtenir des données représentatives de ces signaux, et à traiter ces données par un classificateur qui est de préférence essentiellement constitué par un réseau de neurones structuré, pour délivrer en sortie une (ou plusieurs) donnée(s) caractéristique de la position de l'objet et/ou de la donnée saisie.

L'éclairement de la zone de saisie peut être effectué par une source lumineuse externe au système ; il peut s'agir de la lumière ambiante, naturelle ou artificielle ; cependant, de préférence, le système selon l'invention incorpore au moins une source et généralement plusieurs sources lumineuses d'éclairement de la zone de saisie.

Ainsi, selon un aspect, l'invention propose un procédé de détection de la position d'un objet dans une zone (à deux ou trois dimensions) délimitée par un contour, une surface ou un volume, dans lequel :
- on éclaire la zone à l'aide d'une première pluralité d'émetteurs lumineux,
- on dispose dans la zone et/ou autour de celle-ci une deuxième pluralité de photodétecteurs sensibles à la lumière émise par les émetteurs,
- on convertit en données les signaux délivrés en sortie par les photodétecteurs,
- on applique les données résultant de cette conversion, après un pré-traitement éventuel, à la couche d'entrée (comportant une troisième pluralité de neurones d'entrée) d'un réseau de neurones comportant une couche de sortie (pouvant comporter une quatrième pluralité de neurones de sortie),
- on utilise les données de sortie délivrées par la couche de sortie pour déterminer une ou plusieurs données caractéristiques de l'appartenance de la position de l'objet à une sous zone de contour et/ou de surface (ou volume) prédéterminée de ladite zone, et on en déduit le cas échéant la donnée saisie correspondant à ladite sous zone.

Selon un autre aspect de l'invention, un dispositif de détermination optique de la position d'un objet comporte :
- une première pluralité de photoémetteurs, généralement identiques, aptes à émettre un rayonnement dont la (ou les) longueur(s) d'onde est (ou sont) située(s) dans le domaine de la lumière UV, visible ou infrarouge,
- une deuxième pluralité de photodétecteurs, généralement identiques, aptes chacun à émettre en sortie un signal électrique en fonction du rayonnement lumineux reçu,
- des moyens de conversion connectés auxdits photodétecteurs pour convertir les signaux (analogiques) délivrés par les photodétecteurs en données (numériques),
- un réseau de neurones comportant une couche d'entrée recevant les données délivrées par lesdits moyens de conversion, le cas échéant après pré-traitement de ces données, l'architecture du réseau de neurones étant telle que les données délivrées en sortie du réseau par ladite couche de sortie, soit consistent en (ou représentent) des coordonnées dudit objet dans ladite zone, soit consistent en (ou représentent) des données caractéristiques de l'appartenance de la position dudit objet à une portion prédéterminée de ladite zone.

Selon un quatrième aspect, l'invention consiste à proposer une machine - ou système - de traitement de données comportant un terminal d'entrée de données choisies parmi une cinquième pluralité de données prédéterminées, par approche ou contact d'un objet ou d'un doigt avec une zone d'un substrat comportant une sixième pluralité de portions ou sous zones correspondant respectivement auxdites données prédéterminées, ladite machine comportant :
- des photoémetteurs tels que des diodes électroluminescentes (LED) disposées pour éclairer ladite zone,
- des photorécepteurs tels que des photodiodes disposés pour être sensibles au rayonnement émis par une partie au moins des photoémetteurs,
- des moyens pour générer, à partir des signaux délivrés par les photorécepteurs, des données caractéristiques desdits signaux et le cas échéant de l'état desdits photoémetteurs, et pour appliquer ces données aux neurones d'entrée d'un réseau de neurones,
- un classificateur tel qu'un réseau de neurones, adapté pour fournir en sortie au moins une donnée d'identification d'une desdites sous zones.

En d'autres termes, l'invention repose sur l'utilisation d'un réseau de neurones (ou un moyen équivalent de classification) pour, en fonction des signaux numérisés des photorécepteurs, déterminer laquelle des sous zones ou portions de zone a été approchée ou touchée par un objet non transparent formant un obstacle au rayonnement d'au moins un des photoémetteurs.

Grâce à l'invention, il n'est pas nécessaire, contrairement aux dispositifs de l'art antérieur, que les photoémetteurs et les photorécepteurs soient disposés sur tout le pourtour de la zone éclairée (de saisie) ; il n'est pas non plus nécessaire que les émetteurs et les récepteurs soient alignés en lignes et en colonnes ; il n'est pas non plus nécessaire qu'ils soient régulièrement espacés les uns des autres ; il suffit que d'une part les lobes d'émission des émetteurs, pris dans leur ensemble, éclairent (illuminent) l'ensemble de ladite zone, et que d'autre part les lobes de réception des récepteurs, pris dans leur ensemble, couvrent (englobent) l'ensemble de ladite zone ; ces avantages résultent notamment de la non-linéarité du traitement de données qui est opéré par les neurones d'un réseau de neurones.

Il en résulte pratiquement que, dans le cas notamment d'une zone plane dont le contour est rectangulaire, il n'est pas nécessaire de disposer les photoémetteurs et les photorécepteurs le long d'un petit côté du contour et le long d'un grand côté du contour ; il est notamment rendu possible de disposer les émetteurs le long d'une ligne courbe et/ou avec un espacement variable ; il est également possible de disposer certains des émetteurs à l'extérieur du contour de la zone et de disposer d'autres émetteurs à l'intérieur de ce contour ; il en est de même pour les récepteurs.

Il en résulte en outre qu'il est possible d'utiliser des émetteurs et récepteurs disposés selon une configuration spatiale déterminée avec des zones de saisie de plusieurs formes différentes et/ou avec divers zonages différents ; ceci résulte notamment de l'existence de l'étape d'apprentissage du réseau de neurones, en préalable à la phase d'exploitation (« opérationnelle ») du réseau ; l'apprentissage (généralement supervisé) du réseau de neurones permet en outre, le cas échéant, de structurer le réseau afin qu'il distingue (et/ou reconnaisse) une saisie autorisée d'une saisie non-autorisée ; en effet, en particulier lorsque l'objet est un doigt, il est possible par l'apprentissage et en effectuant successivement des exemples de saisie avec un premier doigt autorisé puis avec un deuxième doigt non autorisé, de structurer le réseau à cet effet.

L'usage d'un réseau de neurones permet donc, outre les fonctions de reconnaissance de données, de rendre indépendants, dans une certaine mesure, la configuration spatiale des émetteurs et récepteurs d'avec la configuration spatiale de la zone de saisie et de sa division en sous-zones ; l'invention facilite notamment la réalisation d'un terminal ou clavier statique rectangulaire dont les émetteurs et les récepteurs sont regroupés le long d'un seul bord du clavier - en prévoyant un réflecteur sur le bord opposé, ou bien le long de deux bords opposés de celui-ci.

L'invention facilite la détection de la position d'un objet sur un substrat zoné non plan.

L'invention facilite par ailleurs la réalisation d'un clavier dont les sous zones de la zone de saisie sont de formes et/ou d'espacement différents.

L'invention a notamment pour conséquence que la finesse (ou résolution) de détection n'est pas proportionnelle au nombre de récepteurs, bien qu'elle soit croissante avec ce nombre ; par ailleurs, la précision et/ou la résolution de détection augmente fortement avec le nombre d'exemples (également appelés échantillons) qui sont utilisés lors de la phase d'apprentissage supervisé du réseau ; en pratique on utilisera généralement une ou plusieurs centaines (ou milliers) d'exemples pour l'apprentissage.

L'invention permet ainsi généralement une réduction du nombre d'émetteurs et récepteurs nécessaires par rapport aux dispositifs connus.

A cet effet, en outre et de préférence, on provoque une émission lumineuse pulsatoire par les émetteurs et on déphase leurs impulsions lumineuses ; on peut par exemple repartir les émetteurs en deux groupes et provoquer successivement l'émission simultanée par tous les émetteurs d'un premier groupe, puis leur extinction suivie de l'émission simultanée par tous les émetteurs d'un deuxième groupe, puis leur extinction ; on dispose alors, pour chaque récepteur, d'une première donnée correspondant au signal de sortie du récepteur pendant l'émission du premier groupe d'émetteurs, et d'une deuxième donnée correspondant au signal de sortie du même récepteur pendant l'émission du deuxième groupe d'émetteurs : on peut regrouper ces données pour l'ensemble des récepteurs, et appliquer simultanément ces données à l'entrée du réseau de neurones ; on fournit ainsi au réseau, pour une position déterminée de l'objet dans la zone, deux fois plus de données qu'avec une émission simultanée de tous les émetteurs ; on augmente ainsi la finesse de classification (et reconnaissance) du réseau et par conséquent la résolution de la détection, sans augmenter le nombre d'émetteurs et/ou de récepteurs.

De façon pratique, on peut pousser plus loin cette méthode en provoquant l'émission successive (avec - ou de préférence sans - recouvrement temporel des émissions successives) de chacun des émetteurs, et en adaptant la structure du réseau de neurones, notamment par augmentation du nombre de neurones formant la couche d'entrée.

Contrairement aux systèmes optiques connus de détection de la position d'un objet dans une zone de détection, dans lesquels le calcul de la position repose sur un modèle mathématique essentiellement constitué d'un système d'équations linéaires, et dans lesquels l'objet est assimilé à un simple écran opaque formant une ombre lorsqu'il est situé dans la zone de saisie, le procédé, le dispositif ou système selon l'invention permettent de tenir compte des caractéristiques optiques et géométriques réelles de l'objet (et/ou du doigt de l'utilisateur), en particulier de son pouvoir de transmission, de réflexion et/ou de rétrodiffusion de la lumière, ainsi que de sa forme.

Le réseau de neurones peut être réalisé sous une forme matérielle (hardware) ; cependant, il est de préférence constitué d'un ou plusieurs module(s) logiciel(s) tels que ceux proposés sous l'appellation MATLAB par la société MATHWORKS (EUA).

Généralement, le nombre d'émetteurs sera situé dans une plage de valeurs allant de 2 à 500, en particulier de 5 à 50, et le nombre de récepteurs sera situé dans une plage de valeurs identique ou similaire à celles-ci.

Le nombre de neurones de la couche de sortie peut être au moins égal à 2, notamment lorsque le réseau délivre en sortie deux (ou trois) coordonnées (cartésiennes, cylindriques ou polaires par exemple) de la position de l'objet dans la zone ; alternativement, ce nombre peut être au moins égal au nombre de sous zones de la zone lorsque chaque neurone de sortie du réseau délivre en sortie une donnée (binaire) représentative de l'appartenance de la position de l'objet à chacune des sous zones prédéterminées de la zone ; altemativement, ce nombre peut être égal à l'unité lorsque le réseau intègre des moyens de codage de la position détectée.

Les moyens de prétraitement des signaux délivrés par les détecteurs - ou des données résultant de la conversion de ces signaux - peuvent incorporer des moyens de filtrage et/ou des moyens de sélection de signaux/données utiles ; de tels moyens de sélection peuvent être prévus pour éliminer sélectivement les signaux (ou données correspondantes) présentant un rapport bruit/signal élevé ; tel peut être notamment le cas lorsqu'un des photodétecteurs n'est pas sensible à l'éclairement de la zone de saisie par un des photoémetteurs ; cela peut notamment être le cas lorsqu'un photodétecteur est disposé à proximité immédiate d'un photoémetteur présentant une émission non omnidirectionnelle, et où le récepteur est situé dans une partie de l'espace non éclairée par l'émetteur : on peut alors dire que le détecteur est aveugle pour cet émetteur, étant situé dans une zone d'ombre pour celui-ci.

Si l'on applique le signal délivré par ce détecteur aveugle, avec ceux délivrés par les détecteurs « non aveugles », - dits « utiles » - à l'entrée du réseau de neurones, il peut en résulter, tant dans la phase d'apprentissage que celle de reconnaissance par le réseau, une instabilité et/ou une erreur importante en sortie; c'est pourquoi il est préférable d'éliminer ces signaux bruités et d'appliquer à l'entrée du réseau de neurones uniquement les données correspondant aux signaux des détecteurs utiles ; à cet effet, le dispositif selon l'invention incorpore de préférence une table ou matrice de sélection des signaux utiles en fonction de l'émetteur considéré ; par conséquent, le nombre de neurones de la couche d'entrée du réseau sera généralement égal au produit du nombre d'émetteurs (ou groupes d'émetteurs) à allumage successif par le nombre (maximal) de récepteurs utiles.

Afin de permettre une détection et/ou une saisie de donnée à une cadence suffisante, la mesure des signaux délivrés par les récepteurs ainsi que le traitement des données résultantes par le réseau de neurones seront effectués plusieurs fois par seconde, en particulier plusieurs dizaines, centaines ou milliers de fois par seconde.

Le nombre de couches intermédiaires du réseau qui relient la couche d'entrée à la couche de sortie, ainsi que le nombre des neurones de ces couches intermédiaires, sont choisis avant le début de l'apprentissage ; les poids synaptiques des liaisons interneuronales sont déterminés par apprentissage.

En pratique, quelques couches ou dizaines de couches intermédiaires comportant chacune quelques neurones ou dizaines de neurones suffiront pour de nombreuses applications.

Selon un mode préféré de réalisation, les émetteurs et récepteurs sont disposés de façon alternée et/ou imbriquée le long de deux portions du contour de la zone de saisie, ce qui permet d'améliorer encore la compacité et la simplicité de leur intégration mécanique, et/ou d'optimiser la couverture de la zone de détection en fonction de la directivité des émetteurs et récepteurs.

L'invention a pour résultat un procédé et un dispositif de détection de position très simple, compact et peu coûteux.

D'autres avantages et caractéristiques de l'invention seront compris au travers de la description suivante qui se réfère aux dessins annexés, qui illustrent sans aucun caractère limitatif des modes préférentiels de réalisation de l'invention.

La figure 1 illustre schématiquement les principaux constituants selon un premier mode de réalisation d'un dispositif selon l'invention.

La figure 2 illustre schématiquement un deuxième mode de réalisation d'un dispositif selon l'invention.

La figure 3 illustre en vue en perspective schématique un clavier d'un dispositif selon l'invention.

La figure 4 illustre schématiquement en vue en plan la disposition d'implantation de quatre LED et de 6 photodiodes d'un dispositif de détection selon l'invention, et la figure 5 illustre une matrice de sélection des détecteurs utiles qui correspond à la configuration de la figure 4.

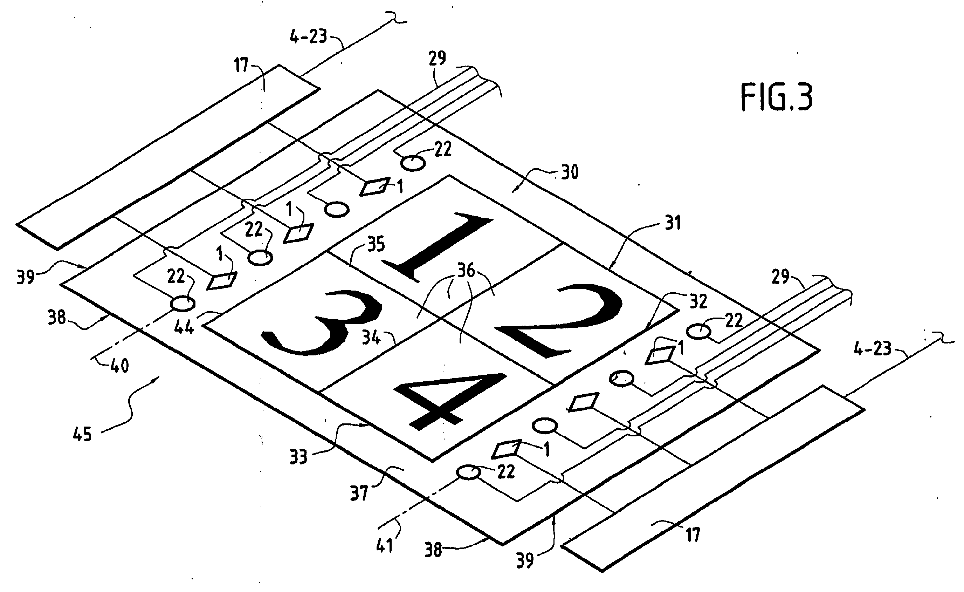

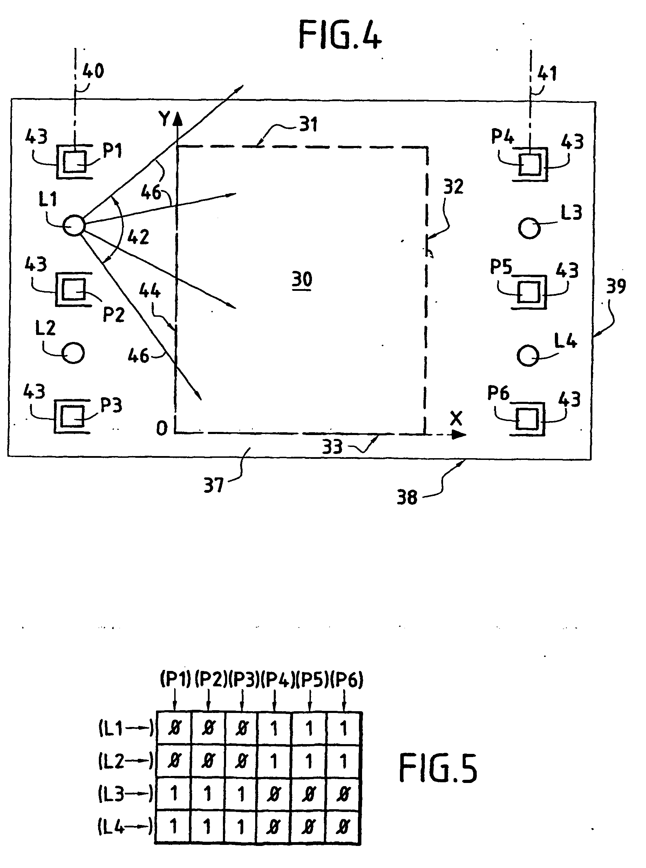

Par référence aux figures 3 et 4, l'invention s'applique en particulier à la détermination de la position d'un organe tel qu'un doigt d'un utilisateur, ou bien d'un outil pour écrire ou pointer tel qu'un style, qui est approché ou mis en contact avec une zone 30 d'un substrat 37 ; la zone 30 rectangulaire est délimitée par quatre segments 31, 32, 33, 44 rectilignes orthogonaux deux à deux. Sur la figure 3, la zone 30 est subdivisée en quatre sous zones 36 rectangulaires délimitées par lesdits segments ainsi que par deux segments 34 et 35 en croix ; quatre signes alphanumériques « 1 », « 2 », « 3 », « 4 » sont respectivement inscrits sur le substrat 37, dans les sous zones 36, constituant quatre données prédéterminées susceptibles d'être saisies par un opérateur.

A cet effet, le terminal 45 (figure 3) comporte trois photodiodes 1 disposées régulièrement espacées le long d'un axe 40 parallèle aux segments 32, 34 et 44, ainsi qu'aux bords courts 39 du substrat 37 ; le terminal comporte en outre quatre LED 22 disposées régulièrement espacées le long de l'axe 40 et alternées avec les capteurs 1 ; un deuxième groupe de trois capteurs 1 et de quatre émetteurs 22 est disposé le long d'un deuxième axe 41 parallèle à l'axe 40 ; les émetteurs 22 et les récepteurs 1 sont montés fixes par rapport au substrat, et peuvent être disposés sensiblement affleurant à la surface du substrat, ou bien à distance au-dessus de cette surface. Sur la figure 4, les émetteurs sont repérés L1 à L4 et les récepteurs sont repérés P1 à P6.

Les sources lumineuses 22, L1 à L4 émettent un rayonnement 46 (figure 4) dans une portion de l'espace en forme de cône centré sur la source et dont l'angle 42 est de préférence suffisant pour que le lobe d'émission de chaque source couvre toute la zone 30.

Un masque 43 est associé à chaque capteur pour le protéger de rayonnement lumineux parasite.

Compte-tenu de la disposition imbriquée en deux rangées parallèles des sources et des capteurs, ainsi que du caractère directionnel de l'émission de chaque source, certains capteurs sont aveugles pour certaines sources ; ainsi, les capteurs P1 à P3 (figure 4) sont aveugles - en transmission - pour chacune des deux sources L1 et L2, tandis que les capteurs P4 à P6 sont aveugles pour chacune des deux sources L3 et L4.

Par conséquent, lorsque par exemple la diode électroluminescente L1 est allumée et les LED L2 à L4 sont éteintes, le signal de sortie des capteurs P1 à P3 est essentiellement constitué de bruit lorsque l'objet à détecter dans la zone 30 est très peu réfléchissant ou rétrodiffusant ; afin d'éviter de « polluer » le traitement des données résultant de la conversion des signaux des capteurs P1 à P6 par les données « bruitées » issues des capteurs P1 à P3, les signaux et/ou les données correspondantes sont éliminées ; cette sélection s'effectue par pondération des signaux par les coefficients « nul » ou « unité » qui sont regroupés dans la table formant la figure 5 : lorsque L1 est activée seule, on sélectionne les signaux utiles délivrés par P4 à P6 et on élimine les signaux délivrés par P1 à P3 ; il en est de même lorsque L2 est seule activée ; la pondération de sélection est inversée lorsque L3 ou L4 sont activées.

Alternativement, si l'objet à détecter dans la zone 30 est très réfléchissant ou rétrodiffusant, il est possible de paramétrer en conséquence les moyens de sélection de signaux utiles : les capteurs P1 à P3 sont aveugles - en réflexion - pour chacune des sources L3 et L4, tandis que les capteurs P4 à P6 sont aveugles - en réflexion - pour chacune des sources L1 et L2 ; la table ou matrice de pondération correspondante aurait alors des coefficients inverses de ceux de la table de la figure 5 : les coefficients "nul" seraient remplacés par des coefficients "unité'', et inversement.

Dans d'autres alternatives, la valeur de chacun des coefficients de cette table pourrait être adaptée en fonction de la position et de la directivité des émetteurs et des récepteurs, ainsi qu'en fonction de l'utilisation des propriétés optiques (transmission et réflexion) et le cas échéant géométriques de l'objet à détecter.

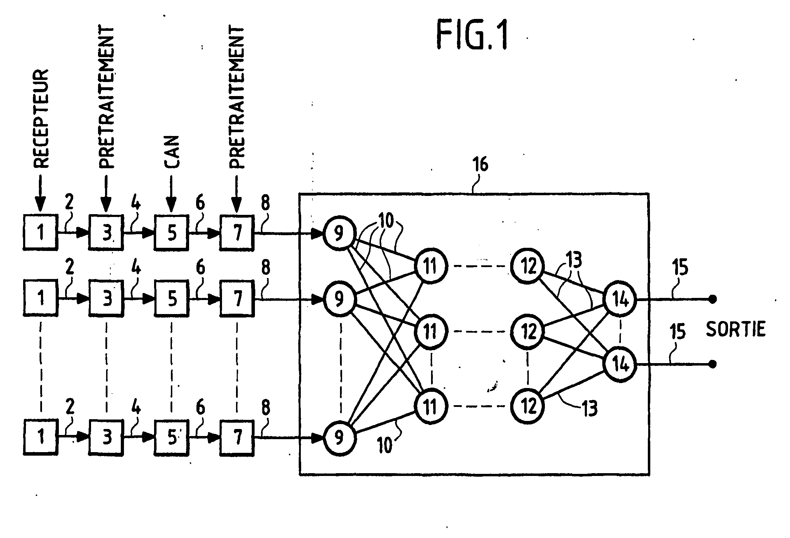

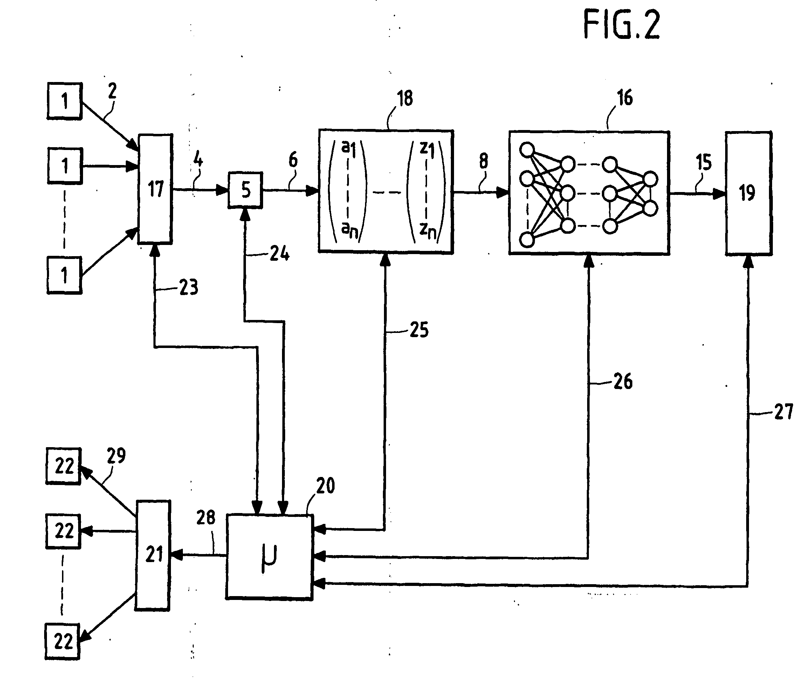

Par référence aux figures 1 et 2 notamment, chacun des capteurs 1 est relié au réseau 16 de neurones (ou perceptron multicouches) par différents moyens raccordés en série.

Sur la figure 1, la sortie de chaque capteur 1 est reliée par une liaison 2 à l'entrée d'une unité 3 de prétraitement du signal délivré par le capteur, telle qu'un filtre ; la sortie de chaque unité 3 est reliée par une liaison 4 à l'entrée d'un convertisseur 5 analogique/numérique ; la sortie de chaque convertisseur 5 est reliée par une liaison 6 à l'entrée d'une unité 7 de prétraitement des données délivrées par le convertisseur ; la sortie de chaque unité 7 est reliée par une liaison 8 à une entrée 9 du réseau 16.

Outre la couche des neurones d'entrée 9, le réseau comporte des couches intermédiaires de neurones 11, 12 et une couche de neurones 14 de sortie qui délivrent en sortie 15 une ou plusieurs données caractérisant la position dans la zone 30 de l'objet à détecter ; des liens synaptiques 10, 13 relient les neurones 9, 11, 12, 14 du réseau 16.

Dans le mode préféré de réalisation illustré figure 2, les signaux délivrés par les capteurs 1 sont délivrés à l'entrée d'un multiplexeur 17 dont la sortie est reliée à un convertisseur 5 unique ; les vecteurs de données (a₁, ..., aₙ).... (Z₁,...., Zₙ) résultant de la conversion des signaux utiles des capteurs 1 sont enregistrées dans une mémoire 18 au fur et à mesure de chaque séquence d'éclairement et d'acquisition de données sous le contrôle d'une unité 20 de commande à microprocesseur qui est respectivement reliée aux organes 17, 5, 7, 16 et à une mémoire 19 de sortie par des liaisons 23 à 27.

L'unité 20 est également reliée par une liaison 28 à un séquenceur 21 dont elle commande le fonctionnement afin d'assurer périodiquement des séquences de balayage lumineux de la zone 30 par les sources 22, par allumage successif, lors de chaque séquence, de toutes les sources ; à cet effet, une liaison 29 relie le séquenceur à chaque source.

## Revendications

1. Procédé pour déterminer la position d'un objet dans une zone (30) d'un substrat (37) comportant plusieurs portions de zone (36), ce procédé comportant les étapes suivantes :
- disposer dans la zone et/ou autour de celle-ci une pluralité de photodétecteurs présentant un lobe de réception, l'ensemble des lobes de réception couvrant l'ensemble de ladite zone,
- structurer un réseau de neurones par apprentissage,
- appliquer à l'entrée du réseau (16) de neurones structuré des données résultant d'une conversion de signaux délivrés par ladite pluralité de photodétecteurs (1, P1,.... P6) sensibles à l'éclairement de ladite zone, et
- déterminer la position de l'objet dans la zone en fonction d'au moins une donnée délivrée en sortie par le réseau de neurones structuré, en déterminant celle desdites portions de zone qui a été touchée ou approchée par l'objet, ledit procédé étant **caractérisé en ce que** :
- pour structurer le réseau de neurones, on procède à un apprentissage supervisé, en présentant successivement à l'entrée du réseau de neurones, plusieurs centaines ou milliers de vecteurs d'exemple chaque vecteur d'exemple comportant une pluralité de données d'exemple résultant d'une conversion de signaux délivrés par ladite pluralité de détecteurs et correspondant à une pluralité de conditions différentes d'éclairement de ladite zone, et dans lequel on éclaire la zone par une pluralité d'émetteurs lumineux (22, L1 à L4) comportant un lobe d'émission, l'ensemble des lobes d'émission illuminant l'ensemble de ladite zone.

2. Procédé selon la revendication 1 dans lequel, pour produire une pluralité de conditions différentes d'éclairement de ladite zone, orr commande l'éclairement successif de la zone par une pluralité de sources (22, L1 à L4) émettant un rayonnement dont la (les) longueur(s) d'onde est (sont) süuée(s) dans le domaine de la lumière UV, visible ou infrarouge.

3. Procédé selon la revendication 1 ou 2, dans lequel on sélectionne des signaux utiles parmi les signaux délivrés par les détecteurs, en éliminant les signaux délivrés par un (ou des) détecteur(s) aveugle(s).

4. Dispositif pour déterminer la position d'un objet dans une zone (30) de détection et/ou de saisie d'un substrat (37) comportant plusieurs portions de zone (36), ce dispositif comportant :
- une pluralité de capteurs (1, P1, ..., P6) sensibles à l'éclairement de la zone et délivrant des signaux électriques en fonction de cet éclairement, l'ensemble des lobes de réception des capteurs couvrant l'ensemble de la zone.
- des moyens (5) de conversion reliés aux capteurs et adaptés pour convertir lesdits signaux en données, et
- des moyens (16) de classification reliés aux moyens de conversion et adaptés pour délivrer en fonction des données résultant de la conversion au moins une donnée de sortie caractérisant la position de l'objet dans la zone, par détermination de la portion de zone touchée ou approchée par l'objet, ledit dispositif étant **caractérisé en ce qu'**il comporte :
- une pluralité de sources (22, L1 à L4) lumineuses adaptées à éclairer la zone de détection et/ou de saisie, l'ensemble des lobes d'émission des sources illuminant l'ensemble de ladite zone, et **en ce que** :
- lesdits moyens de classification comportent un réseau de neurones structuré par un apprentissage supervisé obtenu en présentant successivement à l'entrée dudit réseau de neurones plusieurs centaines ou milliers de vecteurs d'exemple, chaque vecteur d'exemple comportant une pluralité de données d'exemple résultant d'une conversion de signaux délivrés par ladite pluralité de détecteurs et correspondant à une pluralité de conditions différentes d'éclairement de ladite zone par ladite pluralité de sources.

5. Dispositif selon la revendication 4 qui comporte en outre des moyens (7) de sélection de signaux et/ou de données utiles, qui sont reliés aux capteurs et/ou aux moyens de conversion et/ou aux moyens de classification, et qui sont adaptés pour éliminer par filtrage ou pondération par exemple, des signaux bruités et/ou des données résultant de la conversion de signaux bruités.

6. Dispositif selon la revendication 4 ou 5 qui comporte en outre des moyens (21) de balayage lumineux reliés aux sources et adaptés pour commander leur allumage successif.

7. Dispositif selon l'une quelconque des revendications 4 à 6 qui comporte une unité (20) de commande reliée aux moyens (5) de conversion et aux moyens (16) de classification, aux moyens (7) de sélection et aux moyens (21) de balayage, pour commander le fonctionnement de ces moyens, ainsi que des moyens de stockage de données utiles et correspondant à différentes fonctions d'éclairement de la zone, qui se présentent de préférence sous la forme d'une mémoire (18) contenant une table de données utiles regroupant les données de conversion de signaux de chaque capteur utile aux différentes étapes successives d'allumage des sources d'une séquence de balayage lumineux.

8. Terminal (45) de saisie des données qui comporte un dispositif selon l'une quelconque des revendications 4 à 7 ainsi qu'un substrat (37) par rapport auquel les capteurs (1, P1 à P6), ainsi que le cas échéant les sources (22, L1 à L4) sont montés de façon fixe et servant de support de la zone (30) de saisie.

9. Terminal selon la revendication 8 qui comporte deux rangées parallèles de capteurs (1, P1 à P6) et deux rangées parallèles de sources (22, L1 à L4) disposées alternées et/ou imbriquées avec les capteurs, et qui comporte un masque ou capot (43) associé à chaque capteur pour le protéger de rayonnement lumineux parasite.

## Claims

1. A method of determining the position of an article in a zone (30) of a substrate (37) comprising a plurality of zone portions (36), the method comprising the following steps :
- placing a plurality of photodetectors each presenting a reception lobe in and/or around the zone, the set of reception lobes covering all of said zone ;
- structuring a neural network by training ;
- applying to the input of the structured neural network (16) data that results from converting signals delivered by said plurality of photodetectors (1, P1, ..., P6) that are sensitive to illumination of said zone ; and
- determining the position of the article in the zone as a function of at least one data item output by the structured neural network, by determining which of said zone portions has been touched or approached by the article, said method being **characterised in that** :
- in order to structure the neural network, supervised training is performed by presenting the input of the neural network with several hundreds or thousands of example vectors in succession, each example vector comprising a plurality of example data items resulting from converting signals delivered by said plurality of detectors and corresponding to a plurality of different illumination conditions of said zone, and in which the zone is illuminated by a plurality of light emitters (22, L1 to L4) each comprising an emission lobe, the set of emission lobes illuminating all of said zone.

2. A method according to claim 1, in which, in order to produce a plurality of different lighting conditions for said zone, a plurality of sources (22, L1 to L4) are caused to illuminate said zone in succession, the sources emitting radiation of wavelength(s) situated in the UV, visible, or infrared range.

3. A method according to claim 1 or claim 2, in which useful signals are selected from amongst the signals delivered by the detectors, with signals delivered by one or more blind detectors being eliminated.

4. A device for determining the position of an article in an input and/or detection zone (30) of a substrate (37) comprising a plurality of zone portions (36), the device comprising :
- a plurality of sensors (1, P1, ..., P6) sensitive to illumination of the zone and delivering electrical signals as a function of said illumination, the set of reception lobes of the sensors covering all of said zone ;
- converter means (5) connected to the sensors and adapted to convert said signals into data ; and
- classifier means (16) connected to the converter means and adapted to respond to the data that results from the conversion to deliver at least one output data item characteristic of the position of the article in the zone, by determining which portion of the zone the article is touching or is approaching, said device being **characterised in that** it comprises :
- a plurality of light sources (22, L1 to L4) for illuminating the data input and/or detection zone, with the set of emission lobes from the sources illuminating all of said zone, and **in that** :
- said classifier means comprise a neural network structured with supervised training obtained by presenting the input of the neural network with several hundreds or thousands of example vectors in succession, each example vector comprising a plurality of example data items resulting from converting signals delivered by said plurality of detectors and corresponding to a plurality of different illumination conditions of said zone by said plurality of sources.

5. A device according to claim 4, further comprising means (7) for selecting useful data and/or signals, connected to the sensors and/or to the converter means and/or to the classifier means, and adapted to eliminate, e.g. by filtering or by weighting, signals that are noisy and/or data that result from converting noisy signals.

6. A device according to claim 4 or claim 5, further including light scanning means (21) connected to the sources and adapted to cause them to be switched on in succession.

7. A device according to any one of claims 4 to 6, including a control unit (20) connected to the converter means (5) and to the classifier means (16), to the selector means (7), and to the scanner means (21), to control operation of said means, and also means for storing useful data corresponding to various lighting functions of the zone, preferably in the form of a memory (18) containing a table of useful data grouping together the signal conversion data from each useful sensor in the various successive steps of lighting the sources in a light scan sequence.

8. A data input terminal (45) including a device according to any one of claims 4 to 7 together with a substrate (37) relative to which the sensors (1, P1 to P6) and the sources (22, L1 to L4) if any, are mounted in stationary manner and serving as a support for the input zone (30).

9. A terminal according to claim 8, having two parallel rows of sensors (1, P1 to P6) and two parallel rows of sources (22, L1 to L4) disposed in alternation and/or interleaved with the sensors, and including a mask or cover (43) associated with each sensor to protect it from parasitic light radiation.

## Patentansprüche

1. Verfahren zum Festlegen der Position eines Objektes in einem Bereich (30) eines Substrats (37) mit mehreren Bereichsabschnitten (36), wobei dieses Verfahren die folgenden Schritte umfaßt:
- Anordnen einer Vielzahl von eine Empfangskeule aufweisenden Photodetektoren in dem Bereich und/oder um diesen herum, wobei die Gesamtheit der Empfangskeulen den gesamten Bereich abdeckt,
- Strukturieren eines Neuronennetzes durch Lernen,
- Anlegen von Daten, die aus einer Umwandlung von durch die Vielzahl von gegenüber der Beleuchtung des genannten Bereichs empfindlichen Photodetektoren (1, P1, ..., P6) gelieferten Signalen resultieren, an den Eingang des strukturierten Neuronennetzes (16), und
- Bestimmen der Position des Objektes in dem Bereich in Abhängigkeit von wenigstens einer am Ausgang durch das strukturierte Neuronennetz gelieferten gegebenen Größe, durch Bestimmen desjenigen der Bereichsabschnitte, der von dem Objekt berührt wurde oder dem sich das Objekt genähert hat,
wobei das genannte Verfahren **dadurch gekennzeichnet ist, daß**:
- zur Strukturierung des Neuronennetzes ein überwachtes Lernen vollzogen wird, indem am Eingang des Neuronennetzes nacheinander mehrere Hundert oder Tausend Beispielvektoren vorgelegt werden, wobei jeder Beispielvektor eine Vielzahl von Beispieldaten umfaßt, die aus einer Umwandlung von durch die Vielzahl von Detektoren gelieferten Signalen resultieren und die einer Vielzahl von unterschiedlichen Beleuchtungszuständen des Bereichs entsprechen, und bei dem der Bereich durch eine Vielzahl von Lichtsendern (22, L1 bis L4), die eine Sendekeule aufweisen, beleuchtet wird, wobei die Gesamtheit der Sendekeulen den gesamten Bereich beleuchtet.

2. Verfahren nach Anspruch 1, bei dem zur Herstellung einer Vielzahl von unterschiedlichen Beleuchtungszuständen des genannten Bereichs die ununterbrochene Beleuchtung des Bereichs über eine Vielzahl von Quellen (22, L1 bis L4) gesteuert wird, die eine Strahlung aussenden, deren Wellenlänge(n) im Bereich des UV-Lichts, des sichtbaren Lichts oder des Infrarotlichts liegt bzw. liegen.

3. Verfahren nach Anspruch 1 oder 2, bei dem aus den durch die Detektoren gelieferten Signalen nützliche Signale dadurch ausgewählt werden, daß die durch einen (oder mehrere) blinde(n) Detektore(n) gelieferten Signale eliminiert werden.

4. Vorrichtung zum Bestimmen der Position eines Objektes in einem Erkennungs- und/oder Erfassungsbereich (30) eines Substrats (37) mit mehreren Bereichsabschnitten (36), wobei diese Vorrichtung folgendes umfaßt:
- eine Vielzahl von Fühlern (1, P1, ..., P6), die gegenüber der Beleuchtung des Bereichs empfindlich sind und die in Abhängigkeit von dieser Beleuchtung elektrische Signale liefern, wobei die Gesamtheit der Empfangskeulen der Fühler den gesamten Bereich abdeckt,
- Umwandlungsmittel (5), die mit den Fühlern verbunden und die angepaßt sind, um die Signale in Daten umzuwandeln, und
- Klassifikationsmittel (16), die mit den Umwandlungsmitteln verbunden und die angepaßt sind, um in Abhängigkeit von den aus der Umwandlung resultierenden Daten wenigstens eine gegebene Ausgangsgröße zu liefern, welche die Position des Objektes in dem Bereich **kennzeichnet, durch** Bestimmung des Bereichsabschnittes, der von dem Objekt berührt wird oder dem sich das Objekt nähert,
wobei die Vorrichtung **dadurch gekennzeichnet ist**, daß sie folgendes umfaßt:
- eine Vielzahl von Lichtquellen (22, L1 bis L4), die angepaßt sind, den Erkennungs- und/oder Erfassungsbereich zu beleuchten, wobei die Gesamtheit der Sendekeulen der Quellen den gesamten Bereich beleuchtet, und daß:
- die genannten Klassifikationsmittel ein Neuronennetz umfassen, welches **durch** ein überwachtes Lernen strukturiert wird, das **dadurch** erzielt wird, daß nacheinander am Eingang des Neuronennetzes mehrere Hundert oder Tausend Beispielvektoren vorgelegt werden, wobei jeder Beispielvektor eine Vielzahl von Beispieldaten enthält, die aus einer Umwandlung von **durch** die Vielzahl von Detektoren gelieferten Signalen resultieren und die einer Vielzahl von unterschiedlichen Beleuchtungszuständen des Bereichs **durch** die Vielzahl von Quellen entsprechen.

5. Vorrichtung nach Anspruch 4, die ferner Mittel (7) zum Selektieren nützlicher Signale und/oder Daten aufweist, die mit den Fühlern und/oder den Umwandlungsmitteln und/oder den Klassifikationsmitteln verbunden und die angepaßt sind, um beispielsweise durch Filtern oder Gewichtung verrauschte Signale und/oder aus der Umwandlung von verrauschten Signalen resultierende Daten zu eliminieren.

6. Vorrichtung nach Anspruch 4 oder 5, die außerdem Lichtabtastmittel (21) umfaßt, die mit den Quellen verbunden und die angepaßt sind, um deren aufeinanderfolgendes Leuchten zu steuern.

7. Vorrichtung nach irgendeinem der Ansprüche 4 bis 6, die eine Steuereinheit (20), welche mit den Umwandlungsmitteln (5) und den Klassifikationsmitteln (16), mit den Auswahlmitteln (7) und den Abtastmitteln (21) verbunden ist, um den Betrieb dieser Mittel zu steuern, sowie Mittel zur Speicherung von nützlichen und unterschiedlichen Beleuchtungsfunktionen des Bereichs entsprechenden Daten aufweist, die vorzugsweise in Form eines Speichers (18) vorliegen, der ein Verzeichnis nützlicher Daten enthält, welches die Signalumwandlungsdaten eines jeden nützlichen Fühlers zu den unterschiedlichen, aufeinanderfolgenden Abschnitten des Aufleuchtens der Quellen einer Lichtabtastsequenz zusammenfaßt.

8. Terminal (45) zur Erfassung von Daten, das eine Vorrichtung nach irgendeinem der Ansprüche 4 bis 7 sowie ein Substrat (37) umfaßt, gegenüber dem die Fühler (1, P1 bis P6) sowie gegebenenfalls die Quellen (22, L1 bis L4) fest angebracht sind und das dem Erfassungsbereich (30) als Träger dient.

9. Terminal nach Anspruch 8, das zwei parallele Reihen von Fühlern (1, P1 bis P6) sowie zwei parallele Reihen von Quellen (22, L1 bis L4), die abwechselnd und/oder verschachtelt mit den Fühlern angeordnet sind, umfaßt, und das eine Maske oder Blende (43) aufweist, die jedem Fühler zugeordnet ist, um ihn vor parasitärer Lichtstrahlung zu schützen.
